# EUROPEAN PATENT APPLICATION

(11) **EP 0 788 145 A2**
(43) Date of publication of application: **06.08.1997**
(21) Application number: 97101630.8
(22) Date of filing: 03.02.1997
(51) Int. Cl.: H01L 21/285

(54) **Titanium aluminide wetting layer for aluminum contacts**

(30) Priority: 02.02.1996 US 595695
(71) Applicant: APPLIED MATERIALS, INC., Santa Clara, California 95052 (US)
(72) Inventor: Yao, Gongda, Milpitas, CA 95035 (US); XU, Zheng, Foster City, CA 94404 (US); Kieu, Hoa, Sunnyvale, CA 94086 (US)
(74) Representative: Kahler, Kurt, Dipl.-Ing.

(57) **Abstract**

An improved aluminum contact and method of forming it in an opening (12) in a substrate comprising sputter depositing a titanium aluminide wetting layer (16) in the opening (12) and depositing an aluminum layer (18) thereover. The titanium aluminide wetting layer (16) has a controlled thickness.

## Description

This invention relates to improved aluminum contacts. More particularly, this invention relates to improved planarized aluminum contacts and method of making them.

### BACKGROUND OF THE DISCLOSURE

In the manufacture of aluminum contacts for semiconductor devices, a silicon wafer may be doped to provide source and drain areas for transistors and the like. These areas are then covered with a dielectric such as silicon oxide. In order to connect one integrated circuit layer with another, openings are made in the dielectric layer into which a conductive metal layer, such as aluminum or copper, or aluminum alloys containing minor amounts of copper, is deposited. There are several challenges in making such contact openings. When a conductive metal such as aluminum is deposited adjacent to silicon, subsequent elevated temperature processing causes the aluminum and silicon to react to form a metal silicide. Aluminum silicide is also conductive, leading to "spiking" between the aluminum and the silicon junction.

Thus it has been acceptable practice to deposit a barrier layer, such as a titanium nitride layer, into the contact opening prior to aluminum deposition to prevent this spiking. However, titanium nitride has a higher sheet resistance than aluminum, and thus only a thin layer of titanium nitride can be tolerated without adversely affecting the sheet resistivity of the contact. Further, titanium nitride does not wet an overlying aluminum layer well, which leads to adhesion problems between the titanium nitride and the overlying aluminum, i.e., the aluminum delaminates from the titanium nitride. Various methods have been tried to improve the wettability between titanium nitride and aluminum, including depositing a titanium wetting layer over the titanium nitride barrier layer to eliminate the dewetting phenomenon.

However, during subsequent processing, aluminum and titanium react at temperatures as low as about 400°C to form a titanium trialuminide (TiAl₃) region at the interface of the titanium and aluminum, which region has a relatively high sheet resistivity as compared to aluminum, and thus will degrade the conductivity of the aluminum film and thus device performance. Additionally, the titanium consumes some of the aluminum deposited thereon during this reaction, further degrading the conductivity of the aluminum film. For example, for a contact opening lined with 500Å of titanium and filled with aluminum, reaction between them to form TiAl₃ consumes about 1500Å of aluminum. Still further, formation of a thick titanium trialuminide layer as the aluminum is being deposited in the contact can cause premature closure of the contact openings, particularly for small aperture width contacts, leading to the formation of voids in the contacts.

Thus an improved method of forming aluminum contacts over titanium nitride in an opening has been sought.

### SUMMARY OF THE INVENTION

We have found that by sputter depositing a layer of titanium aluminide (TiAlₓ), wherein x is 1-3, having a controlled thickness, into a contact opening as a wetting layer, from 30-60 percent less of the aluminum in the contact is consumed during subsequent processing of the aluminum than when titanium is used as a wetting layer. As a result, the contact sheet resistance of the aluminum contact is both more predictable and lower. Less aluminum needs to be deposited to obtain the same contact sheet resistivity; and planarization of the overlying aluminum layer is improved because the reaction between aluminum and titanium has been greatly reduced..

The contacts of the invention are compatible with dry etch techniques, are readily sputter deposited in a physical vapor deposition (PVD) chamber, and have a sheet resistivity compatible with existing interconnect materials.

### BRIEF DESCRIPTION OF THE DRAWING

Fig. 1 is a cross sectional view of a contact of the invention.

Fig. 2 is a schematic view of a sputtering chamber in which the materials employed in the process of the invention can be deposited.

Fig. 3A is a graph of percent contact fill versus temperature for a hot aluminum deposition.

Fig. 3B is a graph of percent contact fill versus hot/cold ratio of aluminum deposition.

Fig. 3C is a graph of percent contact fill versus power during aluminum deposition.

Fig. 3D is a graph of percent contact fill versus titanium thickness.

Fig. 4A is an SEM photograph of a cross section of a contact made using a titanium wetting layer.

Fig. 4B is a TEM photograph of a cross section of a contact made using a titanium wetting layer showing formation of a titanium aluminide layer.

Fig. 5 is a graph of percent aluminum fill versus titanium aluminide thickness for both hot aluminum deposition and cold/hot aluminum deposition.

Fig. 6 is an SEM photograph of a cross section of a contact made using titanium aluminide as a wetting layer.

Fig. 7 is a TEM photograph of a cross section of a contact made using titanium aluminide as a wetting layer.

Fig. 8 is a plan view of a multi-chamber vacuum deposition system useful for carrying out the present invention.

### DETAILED DESCRIPTION OF THE INVENTION

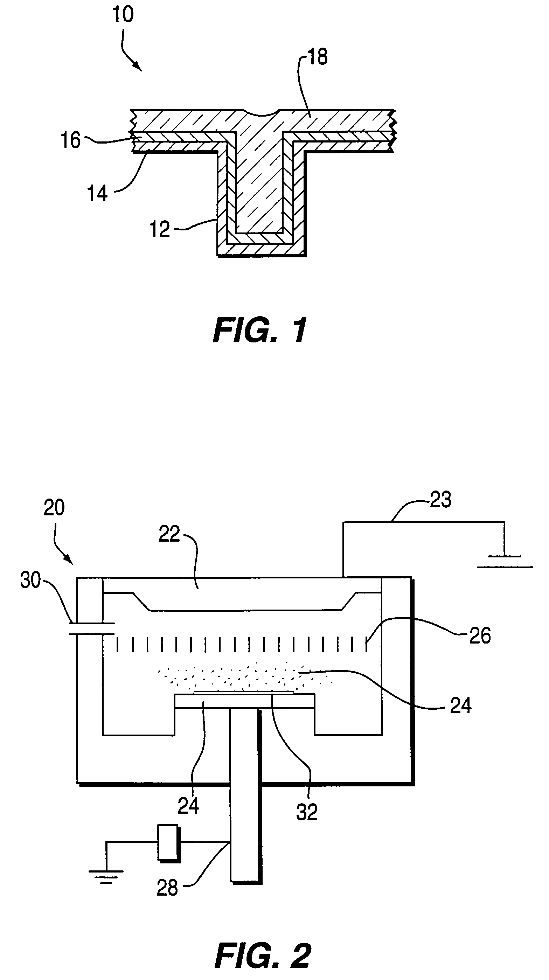

Fig. 1 is an illustration of a contact of the invention. A silicon layer 10 having an opening 12 therein includes a first layer 14 of a barrier material such as titanium nitride, and a wetting layer 16 of TiAlₓ thereover. The opening 12 is then filled with aluminum 18.

According to the method of the invention, a layer of TiAlₓ wherein x is 1-3, is deposited in an aperture such as a via or contact opening, in a substrate such as a silicon wafer or a dielectric film layer by sputtering from a TiAlₓ target such as one containing 37.2% by weight of aluminum, or a ratio of aluminum:titanium of about 3:5, preferably through a collimator. In this manner, a uniform layer of TiAlₓ will be deposited on the sidewalls as well as on the bottom of the aperture, which aperture can have an aspect ratio higher than 2:1. This TiAlₓ layer wets the subsequently deposited overlying aluminum layer when it is deposited thereover. Further, since some aluminum, e.g., about 30 percent, is already present in the TiAlₓ wetting layer, less reaction will occur between the aluminum contact layer deposited thereon and the wetting layer during subsequent processing than when the wetting layer is titanium alone. Since less of the aluminum layer is consumed by the wetting layer, subsequent high temperature processing will affect the aluminum layer much less, preventing an increase in the metal line sheet resistance and preventing void formation in the aluminum layer.

Titanium, titanium nitride, titanium aluminide and aluminum can be sputter deposited in a PVD chamber as shown in Fig. 2.

Referring to Fig. 2, a sputtering chamber 20 includes a desired target 22 connected to a DC power source 23 and a substrate support 24. The target 22 can be of titanium, titanium aluminide or aluminum, depending on the material to be deposited. A collimator 26 is mounted between the target 22 and the substrate support 24. A source of RF power 28 is connected to the substrate support 24. A gas inlet manifold 30 permits various gases, such as argon or nitrogen, to be controllably passed into the chamber. During processing, a substrate 32 is mounted on the substrate support 24.

The preparation of a typical aluminum contact is described hereinbelow. A thin titanium nitride layer, e.g., from about 50-200Å thick, is first deposited in the aperture. This layer can be formed by sputtering a titanium target in the presence of nitrogen gas in the chamber. The titanium nitride layer may be annealed or stuffed with oxygen in known manner if desired.

To carry out the titanium aluminide deposition, a substrate is provided having a plurality of exposed openings in which aluminum contacts are to be formed. After mounting the substrate 32 onto the substrate support 24, a flow of argon is started in the chamber, whereupon titanium aluminide is sputtered from the titanium aluminide target 22 onto the substrate 32. By sputtering through the collimator 26, a layer of TiAl₃ is deposited on the sidewalls in addition to being deposited on the bottom of the exposed openings, and openings having higher aspect ratios can be filled.

In the following example, contact openings in a silicon layer having a layer of thermal silicon oxide thereon were made using standard photolithographic techniques. The contact openings varied in size, i.e., 0.6, 0.8 and 1.0 micron in diameter and were 1.2 microns deep.

### Control - Sputtered Titanium as a Wetting Layer

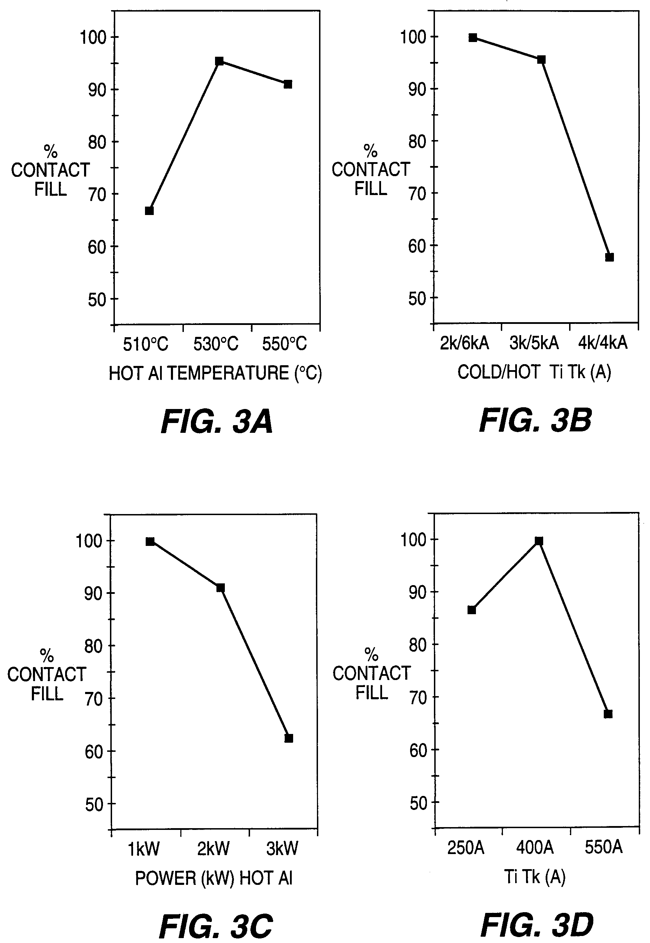

Layers of titanium of various thickness were deposited in contact openings 0.6 micron in diameter having a 2:1 aspect ratio (1.2 micron deep). The titanium was sputter deposited using a 1:1 aspect ratio collimator. Aluminum was sputter deposited over the titanium layers. A determination was made of the aluminum fill and planarization. The deposition of aluminum was also varied and included a hot aluminum deposition (510-550°C), cold/hot aluminum deposition (initial temperature about 400°C with a subsequent increase in temperature to about 500-550°C), and power applied to the target during the deposition. All of the data of Figs. 3A to 3D were measured using 0.6 micron diameter openings.

Fig. 3A illustrates the percent of contact fill for the hot aluminum deposition. The percent fill varies from about 65-96%, with the optimum temperature being about 530°C.

Fig. 3B is a graph of percent contact fill versus temperature of the aluminum deposition which shows that optimum fill is achieved by depositing 2000Å of aluminum cold (400°C) and 6000Å of aluminum hot (530°C), although this can be varied to depositing 3000Å of cold aluminum and 5000Å of hot aluminum with little loss in percentage of contact fill.

Fig. 3C is a graph of percent contact fill versus power during the hot aluminum deposition which shows that the deposition of aluminum at low power is preferred.

The optimum thickness of titanium for wettability and percent contact fill is about 400Å, as shown in Fig. 3D. Since wall coverage is low, only about 14 percent at the bottom of a 2:1 aspect ratio opening, the minimum thickness for the titanium layer is about 50-60Å. At a higher titanium layer thickness of about 500Å, the overhang formed at the top of the opening prevents aluminum reflow into the opening.

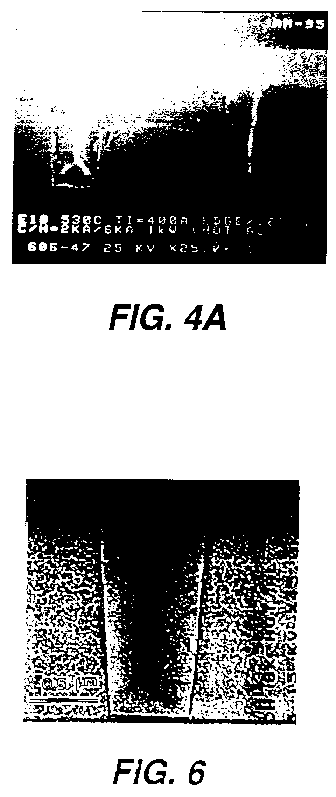

Fig. 4A is a photomicrograph of a cross section of a contact filled with 400Å of titanium and then aluminum deposited by the cold/hot process.

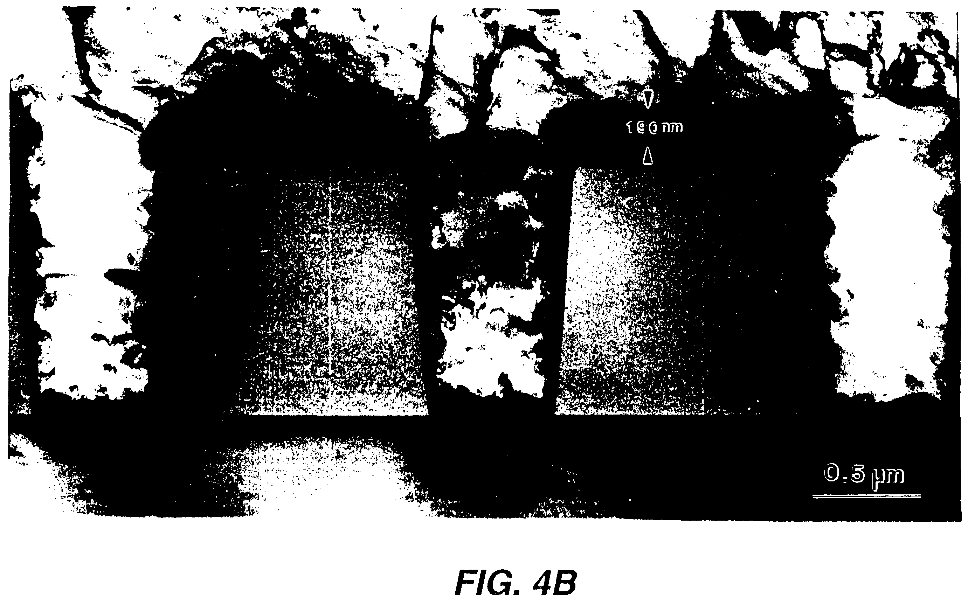

Fig. 4B is a photomicrograph of a TEM analysis of the contact of Fig. 4A. A layer of TiAl₃ about 2000Å thick was measured.

### Example 1 - Sputtered TiAlₓ as a Wetting Layer

After sputter depositing a layer of TiAl₃ into contact openings as in the Control, aluminum was sputter deposited using a 1:1 aspect ratio collimator into the contact openings.

Rutherford Backscattering analysis of the resultant films showed an Al:Ti ratio of about 3.5:1, or that an alloy containing 77.8% of aluminum and 22.2% of titanium was deposited. The resistivity of the TiAl₃ film was 158.96 µohms-cm, which confirms TiAl₃ formation. The sheet resistance uniformity of the sputtered TiAl₃ layer was about 2.266 percent, 1 sigma.

Aluminum was then deposited over the TiAl₃ layer using both the hot and the cold/hot processes.

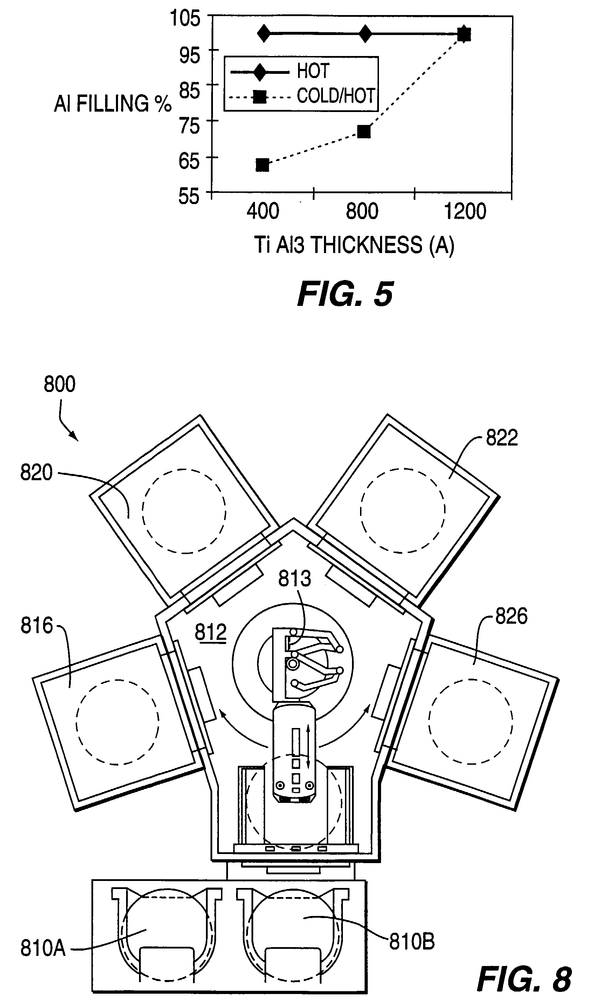

Fig. 5 is a graph of percent fill of the overlying aluminum layer versus TiAl₃ layer thickness in angstroms for aluminum deposited by both the hot deposition and the cold/hot deposition methods. It is apparent that the hot process aluminum deposition gives excellent fill at any film thickness of TiAl₃. When depositing aluminum using the cold/hot process, the optimum percent fill is not obtained until a film of TiAl₃ at least about 1000Å thick is deposited.

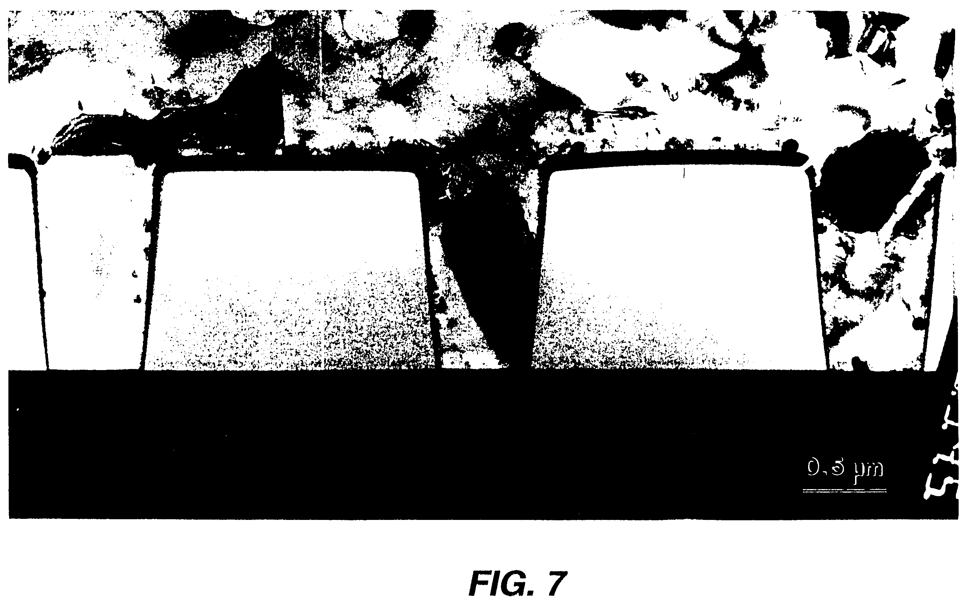

Fig. 6 shows excellent fill of contact openings 0.6 micron in diameter with 400Å of TiAl₃ and 8000Å of aluminum deposited using the hot process.

Fig. 7 is a photomicrograph of a TEM analysis of the interface between a TiAl₃ layer and aluminum.

The above process requires only two sputter deposition chambers; one to sputter deposit the TiAlₓ alloy and a second to sputter deposit aluminum thereover. A suitable multi-chamber deposition system has been disclosed by Maydan et al in US Patent 4,951,601, incorporated hereby by reference, and is shown schematically in Fig. 8.

Fig. 8 illustrates a preferred deposition system in which all of the deposition and treatment steps of the present process can be carried out. This system comprises a plurality of processing vacuum chambers connected to a high vacuum substrate transfer chamber. Each of the processing chambers processes a single wafer at a time, but multiple wafers are accommodated in the system by parallel processing in the various chambers. The system 800 of Fig. 8 includes two independently operated load lock chambers 810A and 810B for loading and unloading substrates into the system. The substrates are transferred from load lock chamber 810A into a substrate transfer chamber 812 which includes a robot 813 for transfer of substrates to various of the connected processing chambers. For example, a preclean chamber 816 can be used to sputter clean or plasma clean the substrate to remove the native oxide layer from air exposed silicon substrates. The substrate can then be transferred to various processing chambers. For example, a titanium nitride layer can be deposited in chamber 820, the titanium aluminide layer can be deposited in chamber 822, and the aluminum layer can be deposited in chamber 826. The coated substrate is then transferred to the load lock chamber 810B for transfer out of the system 800.

Additional processing chambers, as for heating or annealing and the like, can be added to the system 800.

Using a 1:1 aspect ratio collimator, a deposition rate of 2.91Å/kw is achieved.

In a preferred method of forming aluminum contacts, a first layer about 50-200Å thick of titanium nitride is sputter deposited in an opening and annealed in oxygen in conventional manner. The substrate is transferred to a chamber containing a titanium aluminide target and a TiAlₓ layer about 50-500Å thick is deposited using argon gas and a collimator in the chamber.

The substrate is then transferred to another sputtering chamber for the deposition of aluminum.

In a hot aluminum process, the substrate support is heated to a temperature of about 500°C or higher.

Using a cold/hot process, a first deposit of aluminum a few thousand angstroms thick is made at 350-400°C, and the substrate support then heated up to about 550°C and deposition continued to the desired aluminum thickness. The initial cold deposition of aluminum ensures good wetting between the titanium aluminide and aluminum layers. By increasing the temperature during deposition to a temperature above the flow point of the aluminum, e.g., about 550°C, the aluminum flows as it is deposited, eliminating the formation of voids in the aluminum layer. Heated argon can also be passed through the wafer support to raise the temperature of the substrate rapidly.

Only about 3500Å of aluminum is required to fill a contact to obtain the desired sheet resistance. Since little reaction takes place between aluminum and titanium during subsequent high temperature processing, the resistance of the contact remains low.

The stability of the contact resistance has another advantage in that it prevents electron migration effects of the aluminum line during operation of devices. If the aluminum sheet resistance increases over time, as when aluminum is consumed by reaction with titanium, the current density increases and electron migration in the aluminum line also increases, which can lead to breaks in the aluminum line.

Although the invention has been described in terms of specific embodiments, various changes in the materials, reaction conditions, and the like can be made by one skilled in the art and are meant to be included herein.

## Claims

1. A method of depositing an aluminum contact layer into an opening in a substrate comprising in sequence,
a) sputter depositing a layer of titanium aluminide through a collimator to cover the bottom and sidewalls of the opening; and
b) sputter depositing a layer of aluminum thereover.

2. A method according to claim 1 wherein TiAlₓ is sputtered from a TiAlₓ target wherein x is 1-3.

3. A method according to claim 2 wherein TiAlₓ is sputtered to a depth of about 50-500 angstroms.

4. A method according to claim 2 wherein x is about 3.

5. A method according to claim 2 wherein aluminum is sputter deposited over the TiAlₓ layer at a temperature of about 500-550°C.

6. A method according to claim 2 wherein aluminum is sputter deposited over the TiAlₓ layer at a first temperature of about 350-400°C and then sputtered at a second temperature of about 500-550°C to fill said opening.

7. A method according to claim 1 wherein titanium nitride is sputter deposited as a first layer in the opening to a thickness of about 50-200 angstroms.

8. A method according to claim 7 wherein titanium nitride is sputtered in a first physical vapor deposition chamber, titanium aluminide is sputtered in a second physical vapor deposition chamber and aluminum is sputtered in a third physical vapor deposition chamber while maintaining the substrate under vacuum.

9. An aluminum contact comprising a first layer of titanium nitride about 50-200 angstroms thick, a second layer of titanium aluminide (TiAlₓ) wherein x is 1-3 having a controlled thickness of 50-500 angstroms, and a third planarized layer of aluminum.

10. An aluminum contact according to claim 9 wherein x is about 3.
